# EUROPÄISCHE PATENTANMELDUNG

(11) **EP 4 373 228 A1**
(43) Veröffentlichungstag der Anmeldung: **22.05.2024**
(21) Anmeldenummer: 23205795.0
(22) Anmeldetag: 25.10.2023
(51) Int. Cl.: H05K 7/14, H02M 1/00, H02M 7/00, B60L 50/51, B60K 1/00

(54) **WECHSELRICHTER UND ANTRIEBSSTRANG EINES KRAFTFAHRZEUGS**

(30) Priorität: 15.11.2022 DE 102022212114
(71) Anmelder: VOLKSWAGEN AG, 38440 Wolfsburg (DE)
(72) Erfinder: Peters, Johann, 34414 Warburg (DE); Wehry, Eduard, 37213 Witzenhausen (DE); Gronda, Raffael, 34131 Kassel (DE); Dohmann, Mathias, 34212 Melsungen (DE)

(57) **Zusammenfassung**

Wechselrichter (2) mit mindestens einem Gehäuseteil (5), einem Träger (13), einem Leistungsmodul (7) als erstes Funktionsmodul, das mehrere Transistoren (22) zur Wandlung einer elektrischen Gleichspannung in eine Wechselspannung umfasst, und einem, mehreren oder allen der folgenden weiteren Funktionsmodule: Filtermodul (8), Zwischenkreismodul (9), Wechselstrommodul (10), wobei der Träger (13) eine Referenzkontaktfläche (17) aufweist, an der der Gehäuseteil (5) und die vorhandenen Funktionsmodule jeweils direkt anliegen.

## Beschreibung

Die Erfindung betrifft einen Wechselrichter und ein Verfahren zur Herstellung eines solchen Wechselrichters. Der Wechselrichter kann insbesondere als Bestandteil eines elektrischen Antriebsstrangs eines Kraftfahrzeugs vorgesehen sein.

Ein Wechselrichter dient der Umwandlung von Gleichstrom in Wechselstrom. Bei einem elektrischen Antriebsstrang eines Kraftfahrzeugs wird mittels eines solchen Wechselrichters Gleichstrom, der von Batterien des Kraftfahrzeugs bereitgestellt wird, in Wechselstrom, insbesondere dreiphasigen Wechselstrom (Drehstrom), gewandelt, der für den Betrieb mindestens eines elektrischen Traktionsmotors des Kraftfahrzeugs benötigt wird.

Bei der Integration eines Wechselrichters in den Antriebsstrang eines Kraftfahrzeugs besteht die übliche Problematik einer effektiven Ausnutzung des zur Verfügung stehenden Bauraums, so dass eine möglichst kompakte Ausgestaltung des Wechselrichters angestrebt wird. Weiterhin sollten durch eine vorteilhafte Fertigung möglichst geringe Herstellungskosten für einen solchen Wechselrichter realisiert sein.

Die DE 601 02 758 T2 offenbart eine elektronische Steuereinheit, die mehrere elektronische Komponenten innerhalb eines Gehäuses umfasst, wobei die Komponenten mittels Steckkontakten elektrisch verschaltet sind.

Der Erfindung liegt die Aufgabe zugrunde, einen Wechselrichter für insbesondere einen elektrischen Antriebsstrang eines Kraftfahrzeugs anzugeben, der sich durch einen relativ geringen Bauraumbedarf und/oder durch eine vorteilhafte Herstellbarkeit auszeichnet.

Diese Aufgabe ist bei einem Wechselrichter gemäß dem Patentanspruch 1 gelöst. Dieser Wechselrichter kann Bestandteil eines Antriebsstrangs gemäß dem Patentanspruch 12 sein. Ein vorteilhaftes Verfahren zur Herstellung eines solchen Wechselrichters ist Gegenstand des Patentanspruchs 14. Bevorzugte Ausgestaltungsformen des erfindungsgemäßen Wechselrichters und des erfindungsgemäßen Antriebsstrangs sowie vorteilhafte Ausführungsformen des erfindungsgemäßen Verfahrens sind Gegenstände der weiteren Patentansprüche und/oder ergeben sich aus der nachfolgenden Beschreibung der Erfindung.

Erfindungsgemäß ist ein Wechselrichter vorgesehen, der mindestens einen Gehäuseteil, einen Träger, ein Leistungsmodul als ein erstes Funktionsmodul und eines, mehrere oder alle der nachfolgend angeführten weiteren Funktionsmodule umfasst: Filtermodul, Zwischenkreismodul und Wechselstrommodul. Das Leistungsmodul umfasst mehrere Transistoren zur Wandlung einer elektrischen Gleichspannung in eine Wechselspannung. Die Funktionsmodule sind derart ausgestaltet, dass diese grundsätzlich voneinander separiert sind und erst im Rahmen der Herstellung des Wechselrichters miteinander kombiniert und dabei zumindest teilweise elektrisch miteinander verbunden werden. Dabei kann vorgesehen sein, dass die Funktionsmodule, zumindest teilweise, individuelle Modulgehäuse aufweisen, innerhalb der elektronische Komponenten der Funktionsmodule geschützt aufgenommen sind. Der Träger eines erfindungsgemäßen Wechselrichters umfasst eine Referenzkontaktfläche, die vorzugsweise in einer (einzigen) Ebene gelegen ist. An dieser Referenzkontaktfläche liegen zumindest der Gehäuseteil und die Funktionsmodule, soweit vorhanden, direkt an. Vorzugsweise sind die Funktionsmodule dabei mit dem Träger fest und vorzugsweise auch individuell, d.h. unabhängig von den anderen mit dem Träger verbundenen Komponenten, verbunden.

Durch die direkte Anlage sowohl des Gehäuseteils als auch der vorhandenen Funktionsmodule an derselben Referenzkontaktfläche können Toleranzketten hinsichtlich der Positionierung dieser Komponenten, die zu vergleichsweise großen Gesamttoleranzen führen können, vermieden werden. Dadurch ist es möglich, die Funktionsmodule besonders kompakt innerhalb des Gehäuses zu positionieren. Gleichzeitig kann dadurch eine vereinfachte Herstellbarkeit des Wechselrichters realisiert werden.

Ein erfindungsgemäßer Wechselrichter eignet sich aufgrund der kompakten Bauweise, die dessen erfindungsgemäße Ausgestaltung ermöglicht, vorteilhaft zur Verwendung in einem Antriebsstrang eines Kraftfahrzeugs, wobei dieser Antriebsstrang weiterhin zumindest eine Traktionsbatterie und mindestens einen elektrischen Traktionsmotor umfasst. Der Wechselrichter ist dann dafür eingerichtet, einen von der Traktionsbatterie bereitgestellten Gleichstrom in einen Wechselstrom für einen Betrieb des mindestens einen Traktionsmotors zu wandeln.

Die Leistungsmodul kann als Zusammenbaugruppe mehrere Module, vorzugsweise drei Module zur Umwandlung von Gleichstrom zu Wechselstrom und eine unterhalb dieser Module angeordnete Kühleinheit, umfassen. Die Kühleinheit kann weiterhin bevorzugt an einen Kühlkreislauf eines erfindungsgemäßen Antriebsstrangs, in dem vorzugsweise eine Kühlflüssigkeit als Kühlmedium zirkulieren kann, angebunden sein.

Das Filtermodul ist dazu vorgesehen EMV-Störungen (EMV: Elektromagnetische Verträglichkeit) zu unterbinden oder zumindest zu reduzieren. Das Filtermodul kann ein elektrisches Routing, das durch Magnetfelder geführt wird, umfassen.

Das Zwischenkreismodul kann grundsätzlich dazu dienen und dafür eingerichtet sein, eine an dem Wechselrichter anliegende Gleichspannung zu stabilisieren. Hierzu kann das Zwischenkreismodul mindestens einen Kondensator umfassen. Der Kondensator kann eine Baugruppe mit mehreren Wickelelementen, einem positiven (Datenübertragungs-)Bus und einem negativen (Datenübertragungs-)Bus- umfassen. Diese Komponenten sind vorzugsweise über Isolationspapiere voneinander isoliert und in einem Kunststoffgehäuse isolationssicher durch einen Verguss umschlossen.

Das Wechselstrommodul ist dafür eingerichtet, den Wechselstrom in drei Phasen (u, v, w) aus dem Leistungsmodul an einen Wechselstrom-Verbraucher, insbesondere den Traktionsmotor eines erfindungsgemäßen Antriebsstrangs zu leiten.

Eine Ansteuerung der Transistoren des Leistungsmoduls kann insbesondere nach dem Prinzip der Pulsweitenmodulation (PWM) erfolgen. Die Transistoren polen dabei die an dem Leistungsmodul anliegende Gleichspannung periodisch um, wobei über eine variable Dauer der unterschiedlichen Schaltimpulse (variable Pulsweiten) eine bestimmte Form, insbesondere ein Sinusverlauf, des Spannungsverlaufs, erzeugt wird.

Eine elektrische (Reihen-)Verschaltung der elektrischen Komponenten eines erfindungsgemäßen Wechselrichters kann gemäß folgender Routingreihenfolge vorgesehen sein: Filtermodul zu Zwischenkreismodul; Zwischenkreismodul zu Leistungsmodul; Leistungsmodul zu Wechselstrommodul. Bei einer Integration eines solchen Wechselrichters in einen erfindungsgemäßen Antriebsstrang kann zusätzlich folgende Verschaltung vorgesehen sein: Traktionsbatterie zu Filtermodul; Wechselstrommodul zu Traktionsmotor.

Ein erfindungsgemäßes Verfahren zur Herstellung eines erfindungsgemäßen Wechselrichters sieht vor, dass zunächst die vorhandenen Funktionsmodule an dem Träger befestigt werden und anschließend der Träger mit dem Gehäuseteil verbunden wird. Der Träger kann folglich als Basis zu Halterung der Funktionsmodule im Rahmen der Herstellung dienen, wodurch eine einfache, weil nicht durch den Gehäuseteil behinderte Montage der Funktionsmodule erfolgen kann.

Eine hinsichtlich der Außenabmessungen vorteilhafte Ausgestaltung eines erfindungsgemäßen Wechselrichters kann dadurch realisiert sein, dass mindestens zwei der vorhandenen Funktionsmodule entlang einer Positionierausrichtung, die senkrecht zu der Referenzkontaktfläche ausgerichtet ist, nebeneinander angeordnet sind. Sofern ein solcher erfindungsgemäßer Wechselrichter alle der genannten weiteren Funktionsmodule umfasst, kann besonders bevorzugt vorgesehen sein, dass das Filtermodul und das Zwischenkreismodul quer bezüglich der Positionierausrichtung nebeneinander angeordnet sind. Dasselbe kann für das Leistungsmodul und das Wechselstrommodul vorgesehen sein. Das Filtermodul und das Zwischenkreismodul einerseits sowie die Leistungsmodul und das Wechselstrommodul andererseits können dagegen entlang der Positionierausrichtung nebeneinander angeordnet sein.

Zur Realisierung einer möglichst guten Schutzfunktionen für die Funktionsmodule kann vorgesehen sein, dass der Gehäuseteil die vorhandenen Funktionsmodule umgibt beziehungsweise die Funktionsmodule (vorzugsweise vollständig) innerhalb eines Innenraums des Gehäuseteils angeordnet sind.

Gemäß einer bevorzugten Ausgestaltungsform eines erfindungsgemäßen Wechselrichters kann ein erster Positionierstift vorgesehen sein, der mit dem Träger verbunden ist und der in jeweils einer ersten Positionieröffnung des Gehäuseteils und der vorhandenen Funktionsmodule vollumfänglich spielfrei aufgenommen ist (d.h. verhindert ist jede Relativbewegung quer zu einer Verlaufsrichtung/Längsachse der ersten Positionieröffnung). Der erste Positionierstift kann dabei auch in einer ersten Positionieröffnung des Trägers aufgenommen und vorzugsweise kraftschlüssig mit diesem fest verbunden sein. Mittels eines solchen ersten Zentrierstrifts kann bereits eine relativ exakte Positionierung des Gehäuseteils und der Funktionsmodule relativ zu dem Träger und damit auch der Funktionsmodule innerhalb des Gehäuseteils realisiert werden. Dies gilt bei der bevorzugten Ausgestaltung des ersten Positionierstifts mit kreisförmigen Querschnittsflächen zumindest hinsichtlich translatorischer Abweichungen von einer vorgesehenen Positionierung. Weist der erste Positionierstift dagegen nicht-kreisförmige Querschnittsflächen auf, können mittels diesem auch rotatorische Abweichungen (um eine Längsachse des ersten Positionierstifts) von der vorgesehenen Positionierung vermieden werden.

Gemäß einer bevorzugten Weiterbildung eines solchen erfindungsgemäßen Wechselrichters kann zudem ein zweiter Positionierstift vorgesehen sein, der mit dem Träger verbunden ist und der in jeweils einer zweiten Positionieröffnung des Gehäuseteils und der vorhandenen Funktionsmodule aufgenommen ist. Mittels einer solchen Kombination aus mindestens zwei Positionierstiften kann auch dann eine rotatorische Abweichung von einer vorgesehenen Positionierung für die Funktionsmodule relativ zu dem Gehäuse vermieden werden, wenn der erste Positionierstift kreisförmige Querschnittsflächen aufweist, was hinsichtlich der Herstellbarkeit und auch aus Gründen einer vereinfachten Montage bevorzugt ist. Besonders bevorzugt kann dann noch vorgesehen sein, dass die jeweilige Aufnahme des zweiten Positionierstifts in den zweiten Positionieröffnungen (in Grenzen) beweglich bezüglich einer Verlängerung einer die Positionierstifte (beziehungsweise deren Längsachsen) verbindenden Geraden und spielfrei bezüglich derjenigen Richtungen, die senkrecht zu dieser Geraden verlaufen, sind. Dadurch können Toleranzen bezüglich des Abstands der Positionieröffnungen zueinander in den einzelnen Komponenten ausgeglichen werden.

Die Aufnahme des ersten Positionierstifts und/oder des zweiten Positionierstifts in den Positionieröffnungen kann vorzugsweise beweglich (entlang der Längsachse des jeweiligen Zentrierstrifts) vorgesehen sein, so dass keine feste Verbindung des Gehäuseteils und der Funktionsmodule mit dem jeweiligen Positionierstift realisiert ist. Dies wirkt sich vorteilhaft hinsichtlich der Herstellbarkeit des Wechselrichters aus.

Vorteilhaft hinsichtlich der Herstellbarkeit des Wechselrichters kann sich zudem auswirken, wenn der erste Positionierstift und/oder der zweite Positionierstift eine Längsachse aufweist, die senkrecht bezüglich der Referenzkontaktfläche ausgerichtet ist.

Gemäß einer bevorzugten Ausgestaltungsform eines erfindungsgemäßen Wechselrichters kann vorgesehen sein, dass auf einer von der Referenzkontaktfläche abgewandten Seite eine Leiterplatte an dem Träger befestigt ist. Diese Leiterplatte kann sich über im Wesentlichen die gesamte (von der Referenzkontaktfläche abgewandte) Seite des Trägers erstrecken. Dadurch kann sich eine vorteilhafte Nutzung eines von dem mindestens einen Gehäuseteil ausgebildeten Innenraums ergeben. Insbesondere kann die Leiterplatte dadurch auch relativ groß ausgestaltet werden, wodurch entsprechend viel Fläche für die Integration von elektrischen Elementen, insbesondere Leiterbahnen, zur Verfügung steht.

Die Leiterplatte kann ebenfalls zu den Positionieröffnungen der Funktionsmodule vergleichbare Positionieröffnungen aufweisen.

Eine vorteilhafte Herstellbarkeit eines erfindungsgemäßen Wechselrichters kann weiterhin dadurch realisiert sein, dass mindestens zwei und vorzugsweise alle Schweißverbindungen, die zwischen den vorhandenen Funktionsmodulen ausgebildet sind, auf einer (einzigen) Ebene angeordnet sind, die senkrecht zu der Positionierausrichtung ausgerichtet ist. Besonders bevorzugt kann diese Ebene diejenige sein, in der die Referenzkontaktfläche des Trägers verläuft.

Für eine möglichst vorteilhafte Integration des Wechselrichters in den Antriebsstrang kann vorgesehen sein, diesen strukturell in eine andere Komponente des Antriebsstrangs zu integrieren. Hierzu kann insbesondere vorgesehen sein, dass der Gehäuseteil des Wechselrichters auch ein Gehäuseteil der anderen Komponente ist. Diese andere Komponente kann vorzugsweise ein Getriebe sein, das mit dem Traktionsmotor direkt oder indirekt antriebsverbundenen ist, wozu eine Eingangswelle des Getriebes direkt oder indirekt mit einem Rotor des Traktionsmotors antriebsverbundenen sein kann.

Die Erfindung betrifft auch ein Kraftfahrzeug, insbesondere ein radbasiertes und nicht schienengebundenes Kraftfahrzeug (vorzugsweise ein PKW oder ein LKW), mit einem erfindungsgemäßen Antriebsstrang.

Die Erfindung wird nachfolgend anhand von in den Zeichnungen dargestellten Ausgestaltungsbeispielen näher erläutert. In den Zeichnungen zeigt, jeweils in vereinfachter Darstellung:
- Fig. 1:: ein erfindungsgemäßes Kraftfahrzeug;
- Fig. 2:: einen erfindungsgemäßen Wechselrichter in einer Querschnittdarstellung; und
- Fig. 3:: den Wechselrichter gemäß der Fig. 2, jedoch ohne zweites Gehäuseteil, in einer Aufsicht.

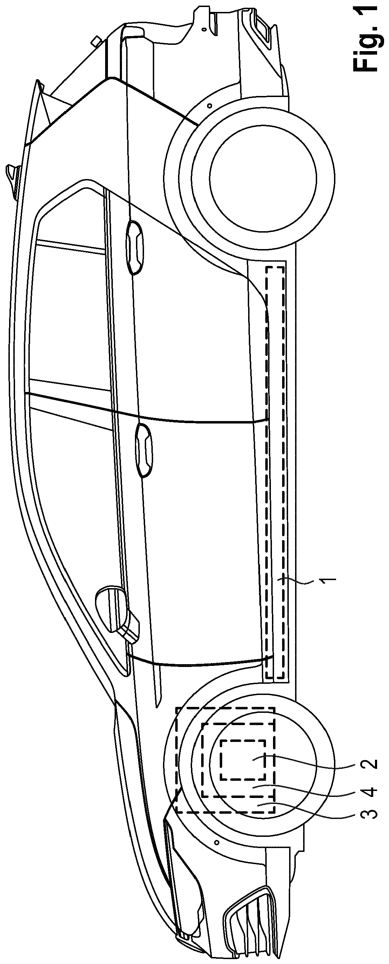

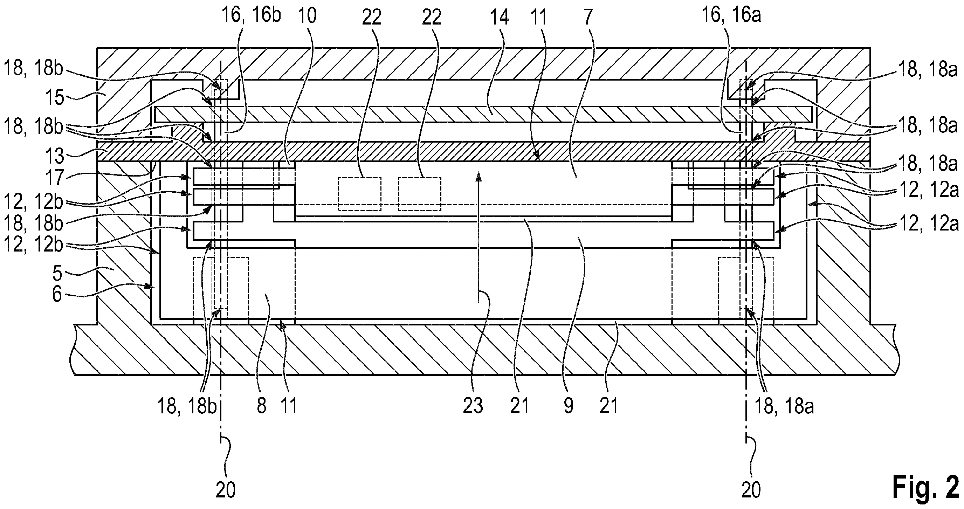

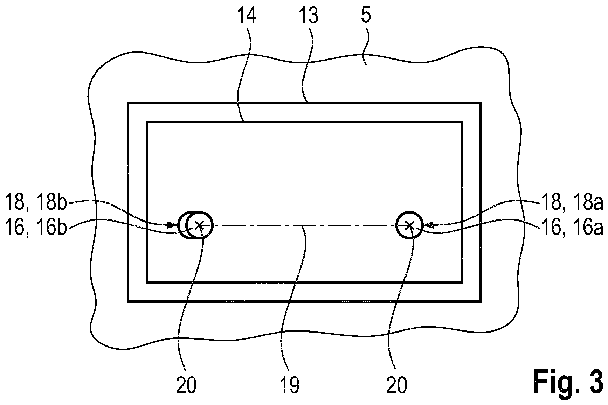

Die Fig. 1 zeigt ein erfindungsgemäßes Kraftfahrzeug. Dieses umfasst einen elektrischen Antriebsstrang mit einer Traktionsbatterie 1, einem erfindungsgemäßen Wechselrichter 2, beispielsweise einem Wechselrichter gemäß den Fig. 2 und 3, sowie einem elektrischen Traktionsmotor 3. Der Traktionsmotor 3 ist über ein schaltbares (d.h. hinsichtlich der Übersetzung veränderliches) oder nicht schaltbares Getriebe 4 des Antriebsstrangs mit angetriebenen Rädern des Kraftfahrzeugs antriebsverbunden. Die Traktionsbatterie 1 ist in einem sogenannten Unterboden einer Karosserie des Kraftfahrzeugs angeordnet. Die Traktionsbatterie 1 stellt bedarfsweise elektrische Energie für einen Betrieb des Traktionsmotors 3 zur Verfügung. Der Wechselrichter 2 ist dafür eingerichtet, den von der Traktionsbatterie 1 bereitgestellten Gleichstrom in Wechselstrom für den Betrieb des Traktionsmotors 3 zu wandeln. Für eine möglichst platzsparende Integration des Wechselrichters 2 ist dieser in ein Gehäuse des Getriebes 4 integriert.

Der Wechselrichter 2 gemäß den Fig. 2 und 3 umfasst einen ersten Gehäuseteil 5, der gleichzeitig auch ein Gehäuseteil des Getriebes 4 sein kann. Ein zu einer Seite hin offener Innenraum 6 des ersten Gehäuseteils 5 nimmt Funktionsmodule des Wechselrichters 2 auf.

Diese Funktionsmodule sind ein Leistungsmodul 7, das mehrere Transistoren 22 aufweist, ein Filtermodul 8, ein Zwischenkreismodul 9 und ein Wechselstrommodul 10. Jedes dieser Funktionsmodule umfasst einen Funktionsabschnitt 11, der die elektrisch wirksamen Komponenten der jeweiligen Funktionsmodule umfasst, sowie jeweils zwei Positionierabschnitte 12, die an sich gegenüberliegenden Seiten des jeweils zugehörigen Funktionsabschnitts 11 angeordnet sind. Der Funktionsabschnitt 11 jedes der Funktionsmodule kann ein Modulgehäuse umfassen, das die zugehörigen elektrischen Elemente teilweise oder vollständig umgibt.

Der Wechselrichter 2 umfasst weiterhin einen Träger 13, eine Leiterplatte 14, einen zweiten Gehäuseteil 15 und zwei Positionierstifte 16.

Der Träger 13 bildet eine ebene Referenzkontaktfläche 17 aus, an der der erste Gehäuseteil 5 und auch alle der Funktionsmodule direkt anliegen. Die Funktionsmodule und der zweite Gehäuseteil 5 sind dabei an dem Träger 13 befestigt, beispielsweise verschraubt. Der Träger 13 kann derart ausgestaltet sein, dass dieser die offene Seite des ersten Gehäuseteils 5 vollständig überdeckt. Der Innenraum 6 des ersten Gehäuseteils 4, der die Funktionsmodule aufnimmt, kann dadurch vollständig verschlossen sein.

Die Leiterplatte 14 liegt an einer von der Referenzkontaktfläche 17 und damit auch von dem ersten Gehäuseteil 5 und den Funktionsmodulen abgewandten Seite an dem Träger 13 an und ist zudem mittels Befestigungselementen (nicht dargestellt), beispielsweise in Form von Schrauben, an diesem befestigt.

Der zweite Gehäuseteil 15 liegt ebenfalls an der von der Referenzkontaktfläche 17 abgewandten Seite an dem Träger 13 an und umgibt die Leiterplatte14.

Eine Positionierung sämtlicher Komponenten des Wechselrichters 2 relativ zueinander in denjenigen Richtungen, die in der Ebene der Referenzkontaktfläche 17 verlaufen, wird durch die Positionierstifte 16 gewährleistet. Hierzu ist ein erster (16a) der Positionierstifte 16, der kreisförmige Querschnittsflächen aufweist (vgl. Fig. 3), spielfrei in jeweils einer entsprechend dimensionierten ersten (18a) von zwei Positionieröffnungen 18 der Gehäuseteile 5, 15, des Trägers 13, der Leiterplatte 14 und der Funktionsmodule aufgenommen. Die ersten Positionieröffnungen 18a der Funktionsmodule sind dabei jeweils in einem ersten (12a) der Positionierabschnitte 12 angeordnet. Dabei ist der erste Positionierstift 16a mittels einer Pressverbindung kraftschlüssig in der ersten Positionieröffnung 18a des Trägers 13 gehalten und dadurch an diesem befestigt.

Weiterhin ist ein zweiter (16b) der Positionierstifte 16 in jeweils einer zweiten Positionieröffnung 18b der Gehäuseteile 5, 15, des Trägers 13, der Leiterplatte 14 und der Funktionsmodule aufgenommen. Die zweiten Positionieröffnungen 18b der Funktionsmodule sind dabei jeweils in einem zweiten (12b) der Positionierabschnitte 12 angeordnet. Der zweite Positionierstift 16b, der ebenfalls kreisförmige Querschnittsflächen aufweist, ist wiederum mittels einer Pressverbindung kraftschlüssig in der zweiten, entsprechend kreisförmig beziehungsweise zylindrisch ausgebildeten Positionieröffnung 18b des Trägers 13 gehalten. Die zweiten Positionieröffnungen 18b der Gehäuseteile 5, 15, der Leiterplatte 14 und der Funktionsmodule sind dagegen nicht kreisförmig sondern als längliche Öffnungen ausgebildet, wobei die jeweilige Breite dieser länglichen zweiten Positionieröffnungen 18b mit einem nur geringen Übermaß dem Durchmesser des zweiten Positionierstifts 16b entspricht, während die Länge dieser länglichen zweiten Positionieröffnungen 18b jeweils größer als dieser Durchmesser ist. Die Länge der zweiten Positionieröffnungen 18b erstreckt sich dabei entlang einer Geraden 19, die die Längsachsen 20 der Positionierstifte 16 miteinander verbindet. Dadurch wird erreicht, dass der zweite Positionierstift 16b in den zweiten Positionieröffnungen 18b beweglich bezüglich dieser Geraden 19 und spielfrei bezüglich derjenigen Richtungen, die quer zu dieser Geraden 19 verlaufen, aufgenommen ist. Die längliche Ausgestaltung der zweiten Positionieröffnungen 18b der Gehäuseteile 5, 15, der Leiterplatte 14 und der Funktionsmodule ermöglicht eine Aufnahme des zweiten Positionierstifts 16b in sämtlichen dieser zweiten Positionieröffnungen 18b trotz möglicher Lagetoleranzen dieser verschiedenen zweiten Positionieröffnungen 18b.

Eine Positionierung der Funktionsmodule und des ersten Gehäuseteils 5 relativ zueinander bezüglich der Richtungen, die senkrecht zu der Referenzkontaktfläche 17 des Trägers 13 verlaufen, wird dadurch erreicht, dass sämtliche dieser Komponenten direkt an der Referenzkontaktfläche 17 des Trägers 13 anliegen. Dadurch werden Toleranzketten bezüglich der Positionierung der Funktionsmodule vermieden und folglich eine möglichst platzsparende Anordnung der Funktionsmodule innerhalb des Innenraums 6 des ersten Gehäuseteils 5 ermöglicht.

Der zweite Gehäuseteil 15, das Leistungsmodul 7 und das Wechselstrommodul 10 sind derart ausgestaltet, dass diese im Bereich ihres jeweiligen Funktionsabschnitts 11 an dem Träger 13 anliegen und daran befestigt sind. Bei dem Filtermodul 8 und dem Zwischenkreismodul 9 erfolgt dies dagegen jeweils im Bereich der zwei zugehörigen Positionierabschnitte 12.

Bei dem dargestellten Ausgestaltungsbeispiels eines erfindungsgemäßen Wechselrichters 2 ist vorgesehen, dass das Filtermodul 8 und das Zwischenkreismodul 9 zumindest abschnittsweise quer bezüglich einer Positionierausrichtung 23, die senkrecht zu der Referenzkontaktfläche 17 ausgerichtet ist, nebeneinander angeordnet sind. Das gleiche gilt für die Kombination aus Leistungsmodul 7 und Wechselstrommodul 10, wobei diese Kombination wiederum entlang der Positionierausrichtung 23 neben der Kombination aus Filtermodul 8 und Zwischenkreismodul 9 angeordnet ist. Bei einer Ausrichtung des Wechselrichters 2 gemäß der Fig. 1 entspricht dies einer Anordnung der zwei Kombinationen übereinander.

In jeweils einem Spalt, der einerseits zwischen dem zweiten Gehäuseteil 15 und dem Filtermodul 8 und andererseits zwischen dem Zwischenkreismodul 9 und dem Leistungsmodul 7 ausgebildet ist, kann gemäß der Fig. 2 ein Wärmeleitmedium 21 angeordnet sein, das flexibel, vorzugsweise pastös ausgestaltet sein kann. Dieses Wärmeleitmedium 21 weist primär oder ausschließlich die Funktion auf, eine Wärmeübertragung zwischen den über das Wärmeleitmedium 21 verbundenen Modulen zu verbessern. Dies kann sich vorteilhaft hinsichtlich der Kühlung der elektrischen Elemente der Funktionsmodule auswirken, wobei eine Wärmeableitung abschließend insbesondere über den ersten Gehäuseteil 5 erfolgen kann.

Die Funktionsmodule sind weiterhin elektrisch miteinander verbunden. Insbesondere kann eine erste elektrische Verbindung zwischen dem Filtermodul 8 und dem Zwischenkreismodul 9 und eine zweite elektrische Verbindung zwischen dem Zwischenkreismodul 9 und dem Leistungsmodul 7 und eine dritte elektrische Verbindung zwischen dem Leistungsmodul 7 und dem Wechselstrommodul 10 vorgesehen sein. Für eine solche elektrische Verbindung können elektrische Kontaktelemente (nicht dargestellt) des einen Funktionsmoduls mit elektrischen Kontaktelementen des anderen Funktionsmoduls kontaktieren, wobei zumindest für einzelne der elektrischen Verbindungen auch eine feste Verbindung, insbesondere durch ein Verschweißen der elektrischen Kontaktelemente umgesetzt sein kann. Für eine vorteilhafte Herstellbarkeit kann dabei vorgesehen sein, dass sämtliche der zu verschweißenden Kontaktelemente in einer Schweißebene angeordnet sind, die der Ebene, in der die Referenzkontaktfläche 17 des Trägers 13 verläuft, entsprechen oder von dieser abweichend kann.

Das Leistungsmodul 7 kann optional mindestens ein Gebläse (nicht dargestellt) umfassen, das insbesondere auf der dem Zwischenkreismodul 9 zugewandten Seite angeordnet sein kann. Durch die Erzeugung eines Kühlluftstroms mittels des Gebläses kann eine ausreichende Kühlung für insbesondere die elektrischen Elemente des Leistungsmoduls 7 gewährleistet werden.

Im Rahmen der Herstellung des Wechselrichters 2 kann vorgesehen sein, zunächst die Positionierstifte 16 in die Positionieröffnungen 18 des Trägers 13 einzupressen und anschließend die Funktionsmodule in einer definierten Reihenfolge auf die Positionierstifte 16 aufzustecken und dann an dem Träger 13 zu befestigen. Anschließend kann auch die Leiterplatte 14 auf die Positionierstifte 16 aufgesteckt und an dem Träger 13 befestigt werden. Daran anschließend oder auch als Zwischenschritte während des Montierens der Funktionsmodule können die elektrischen Verbindungen ausgebildet und gegebenenfalls auch die bei diesen umgesetzten Verschweißungen durchgeführt werden. Darauffolgend kann die so ausgebildete Funktionseinheit in den ersten Gehäuseteil 5 eingesetzt und mit diesem fest verbunden werden. Abschließend kann dann noch der zweite Gehäuseteil 15 mit dem Träger 13 und/oder mit dem ersten Gehäuseteil 5 fest verbunden werden.

### BEZUGSZEICHENLISTE

- 1: Traktionsbatterie
- 2: Wechselrichter
- 3: Traktionsmotor
- 4: Getriebe
- 5: erster Gehäuseteil
- 6: Innenraum des ersten Gehäuseteils
- 7: Leistungsmodul
- 8: Filtermodul
- 9: Zwischenkreismodul
- 10: Wechselstrommodul
- 11: Funktionsabschnitt eines Funktionsmoduls
- 12: Positionierabschnitt eines Funktionsmoduls
- 12a: erster Positionierabschnitt
- 12b: zweiter Positionierabschnitt
- 13: Träger
- 14: Leiterplatte
- 15: zweiter Gehäuseteil
- 16: Positionierstift
- 16a: erster Positionierstift
- 16b: zweiter Positionierstift
- 17: Referenzkontaktfläche
- 18: Positionieröffnung
- 18a: erste Positionieröffnung
- 18b: zweite Positionieröffnung
- 19: Gerade
- 20: Längsachse eines Positionierstifts
- 21: Wärmeleitmedium
- 22: Transistor
- 23: Positionierausrichtung

## Patentansprüche

1. Wechselrichter (2) mit mindestens einem Gehäuseteil (5), einem Träger (13), einem Leistungsmodul (7) als erstes Funktionsmodul, das mehrere Transistoren (22) zur Wandlung einer elektrischen Gleichspannung in eine Wechselspannung umfasst, und einem, mehreren oder allen der folgenden weiteren Funktionsmodule: Filtermodul (8), Zwischenkreismodul (9), Wechselstrommodul (10), **dadurch gekennzeichnet, dass** der Träger (13) eine Referenzkontaktfläche (17) aufweist, an der der Gehäuseteil (5) und die vorhandenen Funktionsmodule jeweils direkt anliegen.

2. Wechselrichter (2) gemäß Anspruch 1, **dadurch gekennzeichnet, dass** die vorhandenen Funktionsmodule individuell an dem Träger (13) befestigt sind.

3. Wechselrichter (2) gemäß einem der vorhergehenden Ansprüche, **dadurch gekennzeichnet, dass** mindestens zwei der vorhandenen Funktionsmodule entlang einer Positionierausrichtung (23), die senkrecht zu der Referenzkontaktfläche (17) ausgerichtet ist, nebeneinander angeordnet sind.

4. Wechselrichter (2) gemäß Anspruch 3, **dadurch gekennzeichnet, dass** alle der weiteren Funktionsmodule vorhanden sind, wobei
• das Filtermodul (8) und das Zwischenkreismodul (9) quer bezüglich der Positionierausrichtung (23) nebeneinander und
• die Leistungsmodul (7) und das Wechselstrommodul (10) quer bezüglich der Positionierausrichtung (23) nebeneinander und
• das Filtermodul (8) und das Zwischenkreismodul (9) einerseits sowie das Leistungsmodul (7) und das Wechselstrommodul (10) andererseits entlang der Positionierausrichtung (23) nebeneinander
angeordnet sind.

5. Wechselrichter (2) gemäß einem der vorhergehenden Ansprüche, **dadurch gekennzeichnet, dass** der Gehäuseteil (5) die vorhandenen Funktionsmodule umgibt.

6. Wechselrichter (2) gemäß einem der vorhergehenden Ansprüche, **gekennzeichnet durch** einen ersten Positionierstift (16a), der mit dem Träger (13) verbunden ist und der in jeweils einer ersten Positionieröffnung (18a) des Gehäuseteils (5) und der vorhandenen Funktionsmodule vollumfänglich spielfrei aufgenommen ist.

7. Wechselrichter (2) gemäß Anspruch 6, **gekennzeichnet durch** einen zweiten Positionierstift (16b), der mit dem Träger (13) verbunden ist und der in jeweils einer zweiten Positionieröffnung (18b) des Gehäuseteils (5) und der vorhandenen Funktionsmodule aufgenommen ist.

8. Wechselrichter (2) gemäß Anspruch 7, **dadurch gekennzeichnet, dass** die jeweilige Aufnahme des zweiten Positionierstifts (16b) in den zweiten Positionieröffnungen (18b) beweglich bezüglich einer Verlängerung einer die Positionierstifte (16) verbindenden Geraden (19) und spielfrei bezüglich derjenigen Richtungen, die senkrecht zu der Geraden (19) verlaufen, ist.

9. Wechselrichter (2) gemäß einem der Ansprüche 6 bis 8, **dadurch gekennzeichnet, dass** der erste Positionierstift (16a) und/oder der zweite Positionierstift (16b) eine Längsachse (20) aufweist, die senkrecht bezüglich der Referenzkontaktfläche (17) ausgerichtet ist.

10. Wechselrichter (2) gemäß einem der vorhergehenden Ansprüche, **dadurch gekennzeichnet, dass** auf einer von der Referenzkontaktfläche (17) abgewandten Seite eine Leiterplatte (14) mit dem Träger (13) verbunden ist.

11. Wechselrichter (2) gemäß einem der vorhergehenden Ansprüche, **dadurch gekennzeichnet, dass** mindestens zwei Schweißverbindungen, die jeweils zwischen zwei der vorhandenen Funktionsmodule ausgebildet sind, auf einer Ebene angeordnet sind, die senkrecht bezüglich einer/der Positionierausrichtung (23) ausgerichtet ist.

12. Antriebsstrang für ein Kraftfahrzeug mit einer Traktionsbatterie (1), einem elektrischen Traktionsmotor (3) und einem Wechselrichter (2) gemäß einem der vorhergehenden Ansprüche, wobei der Wechselrichter (2) dafür eingerichtet ist, einen von der Traktionsbatterie (1) bereitgestellten Gleichstrom in einen Wechselstrom für einen Betrieb des Traktionsmotors (3) zu wandeln.

13. Antriebsstrang gemäß Anspruch 12, **gekennzeichnet durch** ein Getriebe (4), das mit dem Traktionsmotor (3) direkt oder indirekt antriebsverbundenen ist, wobei der Gehäuseteil (5) des Wechselrichters (2) auch ein Gehäuseteil des Getriebes (4) ist.

14. Verfahren zur Herstellung eines Wechselrichters (2) gemäß einem der Ansprüche 1 bis 11, **dadurch gekennzeichnet, dass** zunächst die vorhandenen Funktionsmodule an dem Träger (13) befestigt werden und anschließend der Träger (13) mit dem Gehäuseteil (5) verbunden wird.
